# EUROPEAN PATENT APPLICATION

(11) **EP 4 187 616 A1**
(43) Date of publication of application: **31.05.2023**
(21) Application number: 21210815.3
(22) Date of filing: 26.11.2021
(51) Int. Cl.: H01L 29/778, H01L 29/417, H01L 29/06, H01L 27/06, H01L 29/20, H01L 29/08, H01L 29/10, H01L 29/12, H01L 29/423, H01L 21/338

(54) **A VERTICAL HEMT, AN ELECTRICAL CIRCUIT, AND A METHOD FOR PRODUCING A VERTICAL HEMT**

(71) Applicant: Epinovatech AB, 223 63 Lund (SE)
(72) Inventor: OLSSON, Martin Andreas, 223 63 Lund (SE)
(74) Representative: AWA Sweden AB

(57) **Abstract**

A vertical high-electron-mobility transistor, HEMT (100), comprising:
a substrate (310);
a drain contact (410), the drain contact being a metal contact via through said substrate;
a pillar layer (500) arranged above the drain contact (410) and comprising at least one vertical pillar (510) and a supporting material (520) laterally enclosing the at least one vertical pillar (510);
a heterostructure mesa (600) arranged on the pillar layer (500), the heterostructure mesa (600) comprising an AIGaN-layer (610) and a GaN-layer (620), together forming a heterojunction (630);
at least one source contact (420a, 420b) electrically connected to the heterostructure mesa (600);
a gate contact (430) arranged on said heterostructure mesa (600), and above the at least one vertical pillar (510);
wherein the at least one vertical pillar (510) is forming an electron transport channel between the drain contact (410) and the heterojunction (630).

## Description

### TECHNICAL FIELD

The present inventive concept relates, in general, to a vertical high-electron-mobility transistor, vertical HEMT, to an electrical circuit comprising a vertical HEMT, and to a method of producing a vertical HEMT.

### BACKGROUND

A HEMT is a type of field-effect transistor comprising a heterojunction materials with different band gaps, such as GaN and AIGaN. The orientation of a transistor can be lateral or vertical, meaning that the current flow between the source and the drain contacts of the transistor can be either perpendicular or parallel to the surface of the transistor or a substrate onto which the transistor is based. In a vertical HEMT, the drain contact can be placed at the bottom of the device, while the source contacts can be placed at the top. Transistor operation, i.e. if a current is conducted between the source and drain contacts or not, is controlled by application of a voltage to a gate contact. In more traditional horizontal HEMTs the currents mainly flow through the transistor in the horizontal direction, mediated through the so-called 2-dimensional electron gas, 2DEG, formed at the interface between the heterojunction of different band gap materials. In vertical HEMTs, as the name might suggest, the current flow also comprises a significant vertical component. The main vertically conducting portion of the vertical HEMT is often referred to as the aperture of vertical HEMTs. Vertical HEMTs in general enable improved area downscaling of transistors.

### SUMMARY

It is an objective of the present inventive concept to provide a vertical HEMT for high-frequency operation and/or high-power operation and/or high-temperature operation and/or high voltage operation. It is a further objective to provide a vertical HEMT with a small footprint. These and other objectives of the inventive concept are at least partly met by the invention as defined in the independent claims. Preferred embodiments are set out in the dependent claims.

In this text, abbreviations of the natural elements will be used in accordance with the periodic table. For example, Al means aluminum, Ga means gallium, N means nitrogen, As means arsenic, Mg means magnesium, O means oxygen, Si means silicon, C means carbon.

According to a first aspect, there is provided a vertical high-electron-mobility transistor, HEMT, comprising:
a substrate;
a drain contact, the drain contact being a metal contact via through said substrate;
   a pillar layer arranged above the drain contact and comprising at least one vertical pillar and a supporting material laterally enclosing the at least one vertical pillar;
   a heterostructure mesa arranged on the pillar layer, the heterostructure mesa comprising an AIGaN-layer and a GaN-layer, together forming a heterojunction;
   at least one source contact electrically connected to the heterostructure mesa;
   a gate contact arranged on said heterostructure mesa, and above the at least one vertical pillar;
wherein the at least one vertical pillar is forming an electron transport channel between the drain contact and the heterojunction.

It is a realization that a vertical HEMT may comprise nitride semiconductor material. As used herein, the term nitride semiconductor material should be construed as any semiconductor material comprising nitrogen, in particular alloys of group III and V in the periodic table where the the group V part is nitrogen. The nitride semiconductor material may be GaN based material. As used herein, the term "GaN based material" should be construed as any semiconductor material comprising gallium and nitrogen, e.g. GaN, AIGaN, InGaN, AlInGaN.

GaN based material may facilitate high-frequency operation and/or high-power operation and/or high-temperature operation and/or high voltage operation. Thus, a vertical HEMT comprising GaN based material may operate at high frequencies and/or high power and/or high temperatures and/or at high voltage. Alternatively, or additionally, a vertical HEMT comprising GaN based material may be embedded with electronic devices also made of GaN based material, e.g. embedded in the same chip or on the same substrate.

GaN based HEMTs may offer faster switching speeds, increased electron mobility, lower resistances, larger breakdown voltages, etc. Compared to silicon based transistors, a GaN based device may offer low on-state resistances, and low switching losses when used as power switching transistors for voltage converter applications.

The inventor has realized that a vertical HEMT may be advantageous due resolve the trade-off of low drain current and high breakdown voltage of HEMT devices at high power. Current collapse in GaN HEMT devices is a major limitation of the output power and further on the switching frequency that may be used. Current collapse is generally caused by trapped charges at OFF-state at the AIGaN barrier surface i.e. AIGaN/GaN.

Furthermore, the inventor has realized that a vertical HEMT may provide a larger power density than a conventional HEMT by utilizing the surface area more efficiently for reducing the device size, and further improving the breakdown voltage by allowing a larger gate width than 1 micron.

The vertical HEMT according to the invention comprises a heterojunction formed by an AIGaN-layer and a GaN-layer. Such a heterojunction may, during operation, form a 2-dimensional electron gas, 2DEG, at the interface between the AIGaN-layer and the GaN-layer. Said 2DEG may be formed by applying a voltage to the gate contact. Thus, electrical conduction at the interface between the AIGaN-layer and the GaN-layer may be switched on and off by the gate contact.

Various compositions may be used for the AIGaN-layer of the heterojunction. For example, the AIGaN-layer of the heterojunction may be an Al₍₁₋ₓ₎Ga₍ₓ₎N layer, wherein 0≤x≤0.9, or 0≤x≤0.75. Thus, the AIGaN-layer of the heterojunction may be a pure AlN-layer.

Advantageously, the heterojunction may comprise
an Al₍₁₋ₓ₎Ga₍ₓ₎N-layer with a thickness of 20-22 nm, wherein 0.72≤x≤0.75; and
a GaN layer,
wherein the Al₍₁₋ₓ₎Ga₍ₓ₎N-layer is arranged directly on the GaN layer.

It should be understood that the AIGaN-layer of the heterojunction may comprise two or more sub-layers.

Advantageously, the heterojunction may comprise
a first AIGaN-sublayer, being an Al₍₁₋ₓ₎Ga₍ₓ₎N layer with a thickness of 20-22 nm, wherein 0.72≤x≤0.75;
a second AIGaN-sublayer, being an AIN layer with a thickness below 5 nm; and
a GaN layer,
wherein the second AIGaN-sublayer is arranged directly on the GaN layer and the first AIGaN-sublayer is arranged directly on the second AIGaN-sublayer.

Such thicknesses and compositions of the layers of the heterostructure provide a vertical HEMT with a surprisingly high breakdown voltage and switching speed. It is a realization that the carrier concentration in the 2DEG may depend on the thickness and/or Al concentration of the Al₍₁₋ₓ₎Ga₍ₓ₎N layer. Increasing the thickness and/or Al concentration of the Al₍₁₋ₓ₎Ga₍ₓ₎N may improve the carrier concentration in the 2DEG but around a thickness of 20 nm and an Al concentration of 27% there may be a diminishing return. Similarly, the breakdown voltage of the vertical HEMT may depend on the thickness and/or Al concentration of the Al₍₁₋ₓ₎Ga₍ₓ₎N layer. Taking trade-off effects into account it is a realization that there is a sweetspot when the Al₍₁₋ₓ₎Ga₍ₓ₎N layer has a thickness of 20-22 nm and when 0.72≤x≤0.75. It is further a realization that the use of a thin AIN layer between the Al₍₁₋ₓ₎Ga₍ₓ₎N layer and the GaN layer may improve the breakdown voltage and yet not destroy the positive effects achieved by the Al₍₁₋ₓ₎Ga₍ₓ₎N layer. It should be understood that other parts of the vertical HEMT than the heterojunction may comprise GaN based material. For example, the at least one vertical pillar may comprise GaN based material, such as GaN. The supporting material laterally enclosing the at least one vertical pillar may comprise GaN based material.

According to the invention the vertical HEMT comprises a substrate. The substrate may be any substrate suitable for epitaxial growth. The substrate may comprise silicon, sapphire, silicon carbide, or GaN. In particular, the substrate may be a silicon <111> substrate. In this text, a vertical direction refers to a direction normal to the substrate surface. Similarly, a lateral direction refers to a direction parallel with the substrate surface.

The substrate may be part of a base layer on top of which further layers, such as the pillar layer, are arranged. The base layer may comprise an Al_{(1-y)}Ga_{(y)}N-layer arranged on the substrate, such as directly on the substrate, wherein 0≤y≤1, e.g. 0≤y≤0.9 or 0≤y≤0.75. The Al_{(1-y)}Ga_{(y)}N-layer arranged on the substrate may be an Al_{(1-y)}Ga_{(y)}N-layer deposited by physical vapor deposition (e.g. sputtering) on the substrate. The Al_{(1-y)}Ga_{(y)}N-layer may be a AIN layer, e.g. a sputtered AIN layer, this may enable a low defect density on subsequent layers. Alternatively, the Al_{(1-y)}Ga_{(y)}N-layer 320 may be a GaN layer.

As an example, the vertical HEMT may advantageously comprise a base layer, wherein the base layer comprises the substrate, an AIN layer on the substrate, and a GaN layer on said AIN layer, wherein the substrate is a silicon <111> substrate and said AIN layer and GaN layer are deposited by physical vapor deposition (e.g. sputtering). In the following, the layers will be exemplified as sputtered layers.

The sputtered AIN layer, may function as a transition layer from silicon to GaN based material. The sputtered GaN layer may function as a transition layer to epitaxial GaN based material. It is a realization that such sputtered layers on silicon actually have sufficient, and in fact high, performance. The crystallinity of such layers may in fact be good and epitaxial growth of the AIN and/or GaN layers may not be necessary. Further, sputtered AIN and/or GaN may have fewer charge traps than epitaxially grown layers, e.g. fewer charge traps at the interface between the AlN-layer and the silicon substrate. An InGaN layer may be arranged on top of the GaN layer deposited by physical vapor deposition. Such an InGaN layer may provide a spectroscopic wavelength signal during etching such that etching may be stopped at the correct position. Such an InGaN layer may be sputtered or epitaxially grown. Alternatively the addition of Sc to AIN as sputtered Sc(x)AI(1-x)N may be used as a stop-etch layer.

As mentioned, the vertical HEMT further comprises a drain contact, the drain contact being a metal contact via through said substrate. The metal contact via may be seen as a metal wire in a hole through the substrate. The metal contact via may extend through the substrate in the vertical direction. There may be one metal contact via for each vertical HEMT of a device or electrical circuit. Alternatively, two or more vertical HEMTs of a device or electrical circuit may share one metal contact via. The metal contact via enables one or more vertical HEMTs on the same substrate to have a separate drain connection. Thus, all vertical HEMTs may not need to share a common drain. Thus, a greater design freedom is achieved for designing electrical circuits.

As mentioned, the vertical HEMT further comprises the pillar layer. The pillar layer is arranged above the drain contact. The pillar layer may be arranged directly on top of the drain contact. Alternatively, the pillar layer may be separated from the drain contact by an intermediate layer.

The pillar layer comprises at least one vertical pillar. The least one vertical pillar may have a diameter smaller than 1 µm, such as e.g. between 5 nm and 500 nm. The pillar may advantageously be a nanowire. The nanowire may have a diameter smaller than 100 nm, such as e.g. between 5 and 100 nm or between 10 and 50 nm. A small diameter of the vertical pillar may facilitate a small footprint. Further, a small diameter, such as a diameter below 100 nm, may provide a high charge carrier mobility through quantum confinement effects. This may provide high-frequency operation.

The length of the at least one vertical pillar may be in the range from 50 nm to 500 nm. The length may preferably be in the range from 150 nm to 250 nm.

The at least one vertical pillar may comprise GaN based material, e.g. GaN. The at least one vertical pillar may be doped, e.g. n-doped.

The at least one vertical pillar is configured to form an electron transport channel between the drain contact and the heterojunction.

The at least one vertical pillar may be electrically connected to the drain contact, e.g. by the at least one vertical pillar being arranged directly on top of the drain contact or by a doped region between the pillar and the drain contact. The doped region between the pillar and the drain contact may be a region wherein metal from the drain contact has interdiffused from the drain contact into an intermediate layer between the drain contact and the pillar layer. It is preferred that there is an n-doped region abutting the drain contact on which the pillar layer is formed. Such a layer is advantageous for the etching of the trench in the immediate vicinity of the vertical pillars. It should be understood that the pillars extend along the length of the gate contact and its width. In a non-limiting example, the pillars along the gate width of 3 micrometer it may be 15, and along the gate length of 20 micrometer it may be 100, where the diameter of the pillar is 100 nm and the pitch 100 nm.

The drain contact may extend into the nitride semiconductor layers of the vertical HEMT e.g. into sputtered AIN layers and/or sputtered GaN layers. The drain contact may extend into MOVPE epitaxially grown layers of the vertical HEMT. The drain contact may have a substantially large surface area abutting MOVPE epitaxially grown layers of the vertical HEMT. Thus, the drain contact may be laterally enclosed by an AlN-layer and/or an AIGaN-layer and/or a GaN-layer. The drain contact may be configured to reach within 1 micrometer of the pillar layer, such as within 500 nm of the at least one vertical pillar. Thus, the drain contact may come close enough to the at least one vertical pillar to electrically connect to said at least one vertical pillar.

The supporting material may be configured to be a current blocking layer. The term current blocking layer should be understood as a layer that prevents the current from leaving the electron transport channel. Having the supporting material act as a current blocking layer may reduce current leakage to/from the at least one vertical pillar electron transport channel. In turn, this may lead to reduced transistor losses and higher efficiency operation. The supporting material may e.g. be a nitride semiconductor with a doping opposite to the doping of the at least one vertical pillar. For example, if the at least one vertical pillar is n-doped the supporting material may be p-doped and vice versa. Thus, the pillar layer may be configured to pass an electrical current through the at least one vertical pillar and block a current through the supporting material. Alternatively, the supporting material may be an electrically insulating material. However, it is advantageous with a supporting material of nitride semiconductor material and preferably epitaxially grown nitride semiconductor material. This facilitates epitaxial growth of layers above the pillar layer. According to the above the pillar layer may be configured such that the at least one vertical pillar comprises n-doped GaN and the supporting material comprises a p-doped nitride semiconductor.

As an example of the above, the supporting material may comprise a superlattice of GaN layers and AIN spacer layers. The AIN spacer layers of the supporting material may have a thickness less than 5 nm while the GaN layers of the supporting material have a thickness larger than 5 nm. Alternatively, both the AIN spacer layers and the GaN layers of the supporting material may have a thickness less than 5 nm. All or some of the GaN layers may be carbon-doped or iron-doped. Additionally, or alternatively, all or some of the AIN layers may be carbon-doped or iron-doped. Such supporting material may provide an efficient current blocking layer.

As mentioned, the vertical HEMT further comprises the heterostructure mesa arranged on the pillar layer, the heterostructure mesa comprising the AIGaN-layer and the GaN-layer, together forming the heterojunction. The heterostructure mesa may comprise heterostructure layers, wherein the heterostructure layers comprises the AIGaN-layer and the GaN-layer, together forming the heterojunction.

The mesa may be an etched mesa. Thus, the heterostructure layers may be arranged on the pillar layer after which a mesa is formed, e.g. etched, out of the heterostructure layers. The mesa may be configured such that it comprises the heterostructure layers as well as the pillar layer. Alternatively, the mesa may be configured such that it comprises the heterostructure layers but not the pillar layer.

The formation of the mesa electrically separates the heterojunction of the vertical HEMT from a surrounding, e.g. from the heterojunction of an adjacent vertical HEMT. Thereby, the formation of the mesa enables high-frequency operation and/or high-power operation and/or high voltage operation. The formation of the mesa prevents cross-talk between adjacent vertical HEMTs.

The formation of the mesa reduces parasitic capacitances to a surrounding, such as to an adjacent vertical HEMT. Thereby, the formation of the mesa enables high-frequency operation.

As mentioned, the vertical HEMT further comprises at least one source contact electrically connected to the heterostructure mesa. The at least one source contact may comprise metal. The at least one source contact may be electrically connected to a top surface of the heterostructure mesa. Through the electrical connection to the heterostructure mesa the at least one source contact may be electrically connected to the heterojunction. The heterostructure mesa may e.g. be doped in a region between the at least one source contact and the heterojunction. Alternatively, or additionally, the vertical HEMT may be configured such that the at least one source contact is electrically connected to the heterojunction at least partially by electrical tunnelling.

As mentioned, the vertical HEMT further comprises a gate contact arranged on the heterostructure mesa, and above the at least one vertical pillar. The gate contact may be configured to control the 2DEG at the heterojunction above the at least one vertical pillar. Thus, the vertical HEMT may be configured to provide an electrical path from the at least one source contact via the heterojunction and the at least one pillar to the drain contact, wherein the gate contact may be configured to open and/or close the electrical path by control of the 2DEG at the heterojunction above the at least one vertical pillar. The gate contact may comprise a plurality of layers e.g. a TiN layer on the heterostructure mesa, followed by an Al layer, followed by a TiN layer.

The heterojunction may be configured to form a 2DEG with a substantially large charge density. A layer in the vicinity of the heterojunction may be doped, e.g. n-doped. For example, one of the AIGaN-layer and the GaN-layer forming the heterojunction may be doped. Modulation doping may be used wherein the dopants are spatially separated from the heterojunction interface. Modulation doping may provide a higher crystalline quality of the heterojunction, therefore increasing the 2DEG charge density.

The heterostructure mesa may comprise further layers, in addition to the AlGaN-layer and the GaN-layer forming the heterojunction. For example, the vertical HEMT may comprise a p-doped GaN layer arranged above the AlGaN-layer forming part of the heterojunction, and underneath the gate contact. A p-doped GaN layer between the gate contact and the AlGaN-layer of the heterojunction may enable a vertical HEMT which is normally off. The p-dopant concentration may be 1*10¹⁸ to deplete the 2DEG from electrons and further have a thickness of 50-100 nm and a width similar to the gate length 0.3-5 micron. This may decrease the 2DEG charge density to below 0.48*10¹³ cm⁻² from 1*10¹³ cm⁻² for a normally-off device i.e. in the OFF-state. The device may additionally be configured to have a large 2DEG charge density in the ON-state. Thus, the vertical HEMT may operate in enhancement mode with a low ON-resistance. A normally-off vertical HEMT may be advantageous for high power operation as it may provide a higher reliability of the electrical circuit it is part off.

The p-doped GaN may comprises a superlattice comprising GaN and AI(1-x)Ga(x)N layers, wherein 0.2 ≤ x ≤ 0.4. The superlattice may comprise a plurality of heterostructure layers, wherein each heterostructure layer comprises one GaN layer and one Al(z)Ga(1-z)N layer. The superlattice may provide a p-type two-dimensional hole gas, 2DHG, providing a channel for conduction along an interface between two layers. A periodicity of the superlattice may be between 2 and 6 nm. The p-doping of the superlattice may provide a p-dopant concentration higher than 1*10¹⁸ at room temperature which may provide an improved depletion of the 2DEG.

The AIGaN layer of the heterojunction may be intrinsically doped, the vertical HEMT further comprising:
an intrinsically doped GaN layer arranged above the intrinsically doped AIGaN layer of the heterojunction, and aligned laterally over the at least one vertical pillar, wherein said GaN layer has a thickness of at least 14 nm and a combined thickness of said GaN layer and the AIGaN layer of the heterojunction is in the range 20-50 nm, the AIGaN having a thickness of 20-25 nm.

Such layers may provide a sufficiently depleted 2DEG of the heterojunction to enable high-frequency operation and/or high-power operation and/or high-temperature operation and/or high voltage operation. In particular, when such intrinsically doped layers are combined with a p-doped GaN layer between the gate contact and the intrinsically doped GaN layer a normally-off vertical HEMT may be provided with a high reliability.

The vertical HEMT may be configured to be in a normally-off state and turn on at a threshold voltage of 1 V. The threshold voltage may depend on the distance between the gate contact and the heterojunction. A distance between the gate contact and the heterojunction may be configured such that a voltage difference of at least 1 V between the gate contact and the at least one source contact opens a conductive channel at the heterojunction, whereby the vertical HEMT has a threshold voltage of at least 1 V. The threshold voltage may alternatively, or additionally, depend on a doping profile between the gate contact and the heterojunction. Thus, additionally, or alternatively, a doping profile between the gate contact and the heterojunction may be configured such that a voltage difference of at least 1 V between the gate contact and the at least one source contact opens a conductive channel at the heterojunction, whereby the vertical HEMT has a threshold voltage of at least 1 V. A threshold voltage of at least 1V is advantageous to reduce trigger of the ON-state of the device which could malfunction a circuit of e.g. an electric motor of an electric vehicle and in general to improve reliability of power electronics at high power designed for reliable use at 1 kW or above.

The distance between the drain contact and the source contact may be larger than 4 micrometers. Such a separation between the drain contact and the source contact enables a large breakdown voltage of the vertical HEMT. It may thereby enable high-power operation and/or high voltage operation.

The at least one vertical pillar may be laterally aligned with the gate contact. Thus, the gate contact may laterally overlap with the at least one vertical pillar. Thereby, the gate contact may effectively control the charge transport via the heterojunction to the at least one vertical pillar.

A lateral size of the gate contact may be between 75 % and 150 % of a lateral size of the drain contact. A lateral size of the gate contact may be between 75 % and 150 % of a lateral size of the part of the drain contact that extends into the nitride semiconductor layers of the vertical HEMT. Thus, the same lithography mask may be used to manufacture the gate contact and part of the drain contact. Preferably, the gate contact and the part of the drain contact that extends into the nitride semiconductor layers of the vertical HEMT have the same lateral sizes and are laterally aligned. However, due to differences in exposure during lithography or other manufacturing practicalities the lateral size of the gate contact may be between 75 % and 150 % of a lateral size of the drain contact even if the same lithography mask is used.

The at least one source contact may be laterally separated from the at least one vertical pillar. A lateral separation between the at least one source contact and the at least one vertical pillar may be at least 200 nm. A lateral separation may facilitate a low leakage current when the vertical HEMT is turned off. A lateral separation may facilitate high-power operation and/or high voltage operation.

According to a second aspect there is provided an electrical circuit comprising a first and a second vertical HEMT, the first and second vertical HEMTs being vertical HEMTs according to the first aspect, the electrical circuit comprising an electrical separator configured to block current between the first and second vertical HEMT, the electrical separator comprising:
a first electrical insulator arranged on a lateral side of the heterostructure mesa of at least one of the first and second vertical HEMT; and/or
a second electrical insulator arranged on a lateral side of the at least one source contact of at least one of the first and second vertical HEMT; and/or
a current blocking layer arranged on a lateral side of a GaN vertical connection, the GaN vertical connection being an electrical connection between the at least one source contact and the heterostructure mesa of at least one of the first and second vertical HEMT, wherein said current blocking layer comprises carbon-doped or iron doped GaN.

Thus, two vertical HEMTs may form parts of an electrical circuit. The electrical circuit may be any kind of electrical circuit, e.g. a buck converter or a boost converter. The first and a second vertical HEMT may share a common substrate. The electrical separator enables a small separation between the first and a second vertical HEMT. Thus, the electrical circuit may have a small footprint. Further, electrical separator reduces parasitic capacitances between the first and a second vertical HEMT. Thereby, the electrical separator enables high-frequency operation of the electrical circuit.

The first electrical insulator may be an oxide. The first electrical insulator may be high-frequency deposited plasma-enhanced chemical vapor deposition oxide (HDPOX) or low-frequency deposited plasma-enhanced chemical vapor deposition oxide (LDPOX), or phosphosilicate glass (PSG) or any combination thereof.

The second electrical insulator may be an oxide. The second electrical insulator may be HDPOX or LDPOX, or PSG or any combination thereof.

The current blocking layer arranged on a lateral side of the GaN vertical connection may comprise a superlattice of GaN layers and AIN spacer layers. The AIN spacer layers of the current blocking layer may have a thickness less than 5 nm while the GaN layers of the current blocking layer have a thickness larger than 5 nm. Alternatively, both the AIN spacer layers and the GaN layers of the current blocking layer may have a thickness less than 5 nm. All or some of the GaN layers may be carbon-doped or iron-doped. Additionally, or alternatively, all or some of the AIN layers may be carbon-doped or iron-doped. The GaN vertical connection may be n-doped.

According to a third aspect there is provided a method for producing a vertical HEMT, the method comprising
providing a base layer wherein the base layer comprises a substrate;
forming a pillar layer on the base layer, wherein the pillar layer comprises at least one vertical pillar and a supporting material laterally enclosing the at least one vertical pillar;
forming a heterostructure mesa on the pillar layer, the heterostructure mesa comprising an AlGaN-layer and a GaN-layer, together forming a heterojunction;
forming at least one source contact electrically connected to the heterostructure mesa;
forming a gate contact above both the heterostructure mesa and the at least one vertical pillar; and
forming a drain contact electrically connected to the at least one vertical pillar, the drain contact being a metal contact via through the substrate;
wherein the at least one vertical pillar is forming an electron transport channel between the drain contact and the heterojunction.

The base layer may comprise an Al_{(1-y)}Ga_{(y)}N-layer on the substrate, wherein said Al_{(1-y)}Ga_{(y)}N-layer is sputtered epitaxially aligned with the crystal orientation of the substrate, preferably wherein said substrate is silicon <111> and said composition y is either 0 or 1, or a value therebetween.

The method may further comprise forming a current blocking layer by epitaxial regrowth of iron-doped or carbon-doped GaN.

The method may further comprise providing the gate contact with a field plate. The field plate is a metal extension of the gate contact, e.g. at an upper portion of the gate contact, the field plate being vertically separated from the underlying semiconductor. The field plate may be vertically separated from the underlying semiconductor by a dielectric material, e.g. Al₂O₃. The field plate is opposing the electric field on the gate, and increase the breakdown voltage of the device.

The method may further comprise providing said at least one source contact with a field plate, said field plate extending above the gate contact. Thus, the field plate of the source contact may extend as a metal extension above the gate contact. The field plate of the source contact may be separated from the gate contact by a dielectric material.

For example, the method may comprise arranging a first source contact on one side of the gate contact and a second source contact on the other side of the gate contact and providing a common field plate between the first and second source contact, the common field plate extending above the gate contact.

Herein said source contacts may comprise bond pins arranged unipotential.

The method may further comprise:
depositing a first electrical insulator on a lateral side of the heterostructure; and/or
depositing a second electrical insulator on a lateral side of the at least one source contact; and/or
creating a current blocking layer on a lateral side of a GaN connection between the at least one source contact and the heterostructure.

Forming the drain contact may comprise etching through at least part of a silicon substrate by deep reactive ion etching.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
- Fig. 1: illustrates a vertical HEMT
- Fig. 2: illustrates a vertical HEMT
- Fig. 3: illustrates a vertical HEMT
- Fig. 4: illustrates a vertical HEMT
- Fig. 5: illustrates an electrical circuit comprising two vertical HEMTs
- Fig. 6: illustrates a vertical HEMT
- Fig. 7: illustrates a flow chart of a method
- Fig. 8: illustrates a vertical HEMT
- Fig. 9: illustrates a vertical HEMT

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

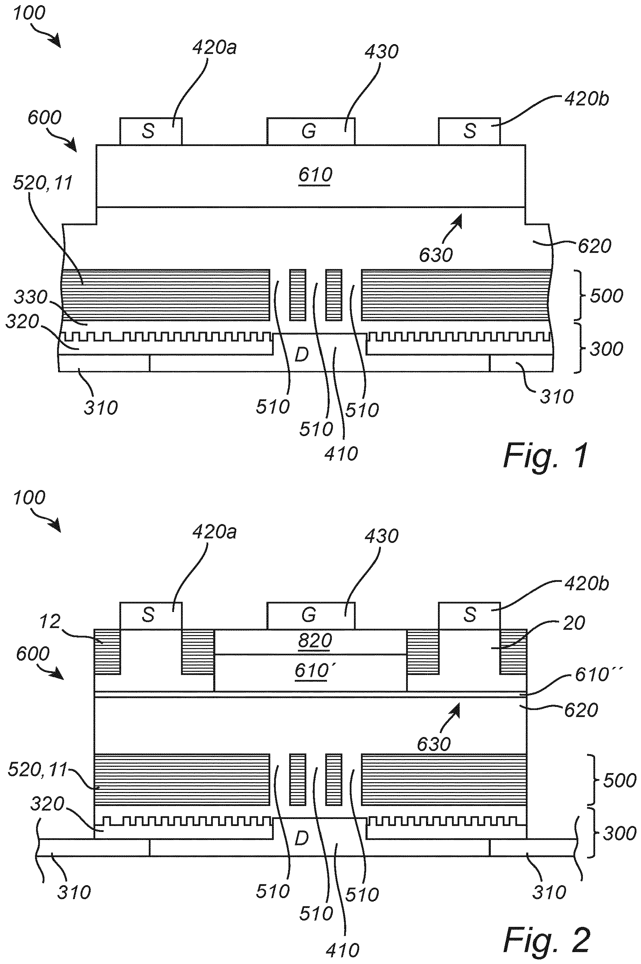

Fig. 1-4 illustrates cross-sectional views of vertical HEMTs 100. Each illustrated vertical HEMT 100 comprises a base layer 300. The base layer 300 comprising a substrate 310 and further nitride semiconductor layers. The substrate 310 may be a silicon <111> substrate. In the illustrations, the the base layer comprises the substrate, an AIN layer 320 on the substrate 310, and a GaN layer 330 on said AIN layer 320. The AIN layer 320 and/or the GaN layer 330 may be sputtered layers. The AIN layer 320 may comprise a corrugated surface. For example, the AIN layer 320 may comprise AIN pillars, as illustrated. The AIN pillars of the AIN layer 320 will in the following be called base layer pillars. Such base layer pillars facilitates a low defect density in subsequent layers.

It should be understood that the illustrations are schematic. For example, in reality the substrate 310 is generally substantially thicker than the layers it supports.

Each illustrated vertical HEMT 100 further comprises a drain contact 410, the drain contact 410 being a metal contact via through the substrate 310. As illustrated, the drain contact 410 may extend into the nitride semiconductor layers of the vertical HEMT 100. In the illustrations the drain contact 410 extends into the AIN layer 320 and into the GaN layer 330. Thus, the drain contact may be laterally enclosed by an AlN-layer and/or an AIGaN-layer and/or a GaN-layer.

Each illustrated vertical HEMT 100 further comprises a pillar layer 500 arranged above the drain contact 410. Each illustrated pillar layer 500 comprises three vertical pillars 510 but the pillar layer 500 may of course comprise any number of vertical pillars 510, such as e.g. 1, 2, or 10 vertical pillars 510. In the illustrations the vertical pillars 510 are separated from the drain contact 410 by the GaN layer 330. Alternatively, or additionally, the vertical pillars 510 may be separated from the drain contact 410 by another layer, e.g. an epitaxially grown layer, e.g. an epitaxially grown GaN layer. A region between the vertical pillar 510 and the drain contact 410 may be doped, e.g. n-doped, to provide electrical contact therebetween. Alternatively, the vertical pillars 510 may be in direct contact with the drain contact 410. Each illustrated pillar layer 500 comprises supporting material 520 laterally enclosing the vertical pillars 510. In the illustrations the supporting material 520 is configured to be a first current blocking layer 11. The first current blocking layer 11 in the illustrations comprises a superlattice of GaN layers and AIN interlayers wherein the AIN interlayers have a thickness less than 5 nm. The GaN layers of the superlattice is carbon-doped or iron-doped. The vertical pillars 510 may herein comprise n-doped GaN. It should be understood that although the superlattice blocks the current efficiently, in some cases it may be sufficient to use a semiconductor with opposite doping to the vertical pillars 510. For example, if n-doped GaN vertical pillars 510 are used the current blocking layer may be p-doped GaN or AIGaN.

Each illustrated vertical HEMT 100 further comprises a heterojunction 630 formed out of an AlGaN-layer 610 and a GaN-layer 620. The AlGaN-layer 610 may be an Al₍₁₋ₓ₎Ga₍ₓ₎N layer, wherein 0≤x≤0.9, or 0≤x≤0.75.

Advantageously, the heterojunction 630 may comprise
an Al₍₁₋ₓ₎Ga₍ₓ₎N-layer 610 with a thickness of 20-22 nm, wherein 0.72≤x≤0.75; and
a GaN layer 620,
wherein the Al₍₁₋ₓ₎Ga₍ₓ₎N -layer 610 is arranged directly on the GaN layer 620.

It should be understood that the AlGaN-layer of the heterojunction 630 may comprise two or more sub-layers.

Advantageously, the heterojunction 630 may comprise
a first AlGaN-sublayer 610', being an Al₍₁₋ₓ₎Ga₍ₓ₎N layer with a thickness of 20-22 nm, wherein 0.72≤x≤0.75;
a second AlGaN-sublayer 610", being an AIN layer with a thickness below 5 nm; and
a GaN layer 620,
wherein the second AlGaN-sublayer 610" is arranged directly on the GaN layer and the first AlGaN-sublayer 610' is arranged directly on the second AlGaN-sublayer 610".

For example, as illustrated in Figs. 2-4, the AlGaN-layer 610 may comprise a first AlGaN-sublayer 610' and a second AlGaN-sublayer 610". The second AlGaN-sublayer 610" may have a higher Al content than the first AlGaN-sublayer 610' and lie between the first AlGaN-sublayer 610' and the GaN-layer 620. Further, second AlGaN-sublayer 610" may have a thickness below 5 nm. In particular, the second AlGaN-sublayer 610" may be a 1 nm thin AIN spacer at the heterojunction 630 and the first AlGaN-sublayer 610' may be an Al_{(0.27)}Ga_{(0.73)}N layer.

For each illustrated vertical HEMT 100, a mesa is etched out of the nitride semiconductor structure. The mesa extending at least through the heterojunction 630. Thus, the AlGaN-layer 610 and the GaN-layer 620 are parts of a heterostructure mesa 600 arranged on the pillar layer 500. In Fig. 1 the etched mesa goes down to slightly below the heterojunction 630, i.e. the bottom of the etched mesa is slightly below the heterojunction 630. In this case the etched mesa is the heterostructure mesa 600 arranged on the pillar layer 500. In Figs. 2-4 the etched mesa goes down to the substrate 310, i.e. the bottom of the etched mesa is at the substrate 310. In this case the part of the etched mesa above the pillar layer 500 is the heterostructure mesa 600 arranged on the pillar layer 500.

Each illustrated vertical HEMT 100 further comprises two source contacts 420a, 420b electrically connected to the heterostructure mesa 600. Through the electrical connection to the heterostructure mesa 600 the source contacts 420a, 420b may be electrically connected to the heterojunction 630. The heterostructure mesa 600 may e.g. be doped in a region between the source contacts 420a, 420b and the heterojunction 630. Said doped region may be a doped region, e.g. n-doped region, in the AlGaN-layer 610. For example, in Fig. 1 a region of the AlGaN-layer 610 between the source contact 420a, 420b and the heterojunction 630 may be n-doped. Alternatively, there may be a vertical connection 20 from a source contact 420a, 420b leading to a point close to, e.g. within 100 nm of, the heterojunction 630. The vertical connection may herein be doped, e.g. n-doped, GaN. Such vertical connections 20 are illustrated in Figs. 2-4 wherein the vertical connections 20 are n-doped GaN leading from each source contact 420a, 420b to the AIN spacer 610". The source contacts 420a, 420b may comprise metal, e.g. Ni and/or Al, such as a double layer of Ni/AI.

Each illustrated vertical HEMT 100 further comprises a gate contact 430 arranged on the heterostructure mesa 600, and above the vertical pillars 510. As illustrated the vertical pillars 510 may be laterally aligned with the gate contact 430 so that the gate contact 430 laterally overlaps with the vertical pillars 510. Thus, all vertical pillars 510 may lie below the gate contact 430. The gate contact 430 may comprise metal, e.g. Ti and/or Al and/or NiV, such as a triple layer of Ti/Al/NiV or TiN/Al/TiN.

As illustrated in Figs. 1-3 the gate contact 430 and the part of the drain contact 410 that extends into the nitride semiconductor layers of the vertical HEMT, in this case into the AIN layer 320 and the GaN layer 330, have the same lateral sizes and are laterally aligned. Thus, the gate contact 430 and the part of the drain contact 410 that extends into the nitride semiconductor layers of the vertical HEMT may be manufactured using the same lithography mask.

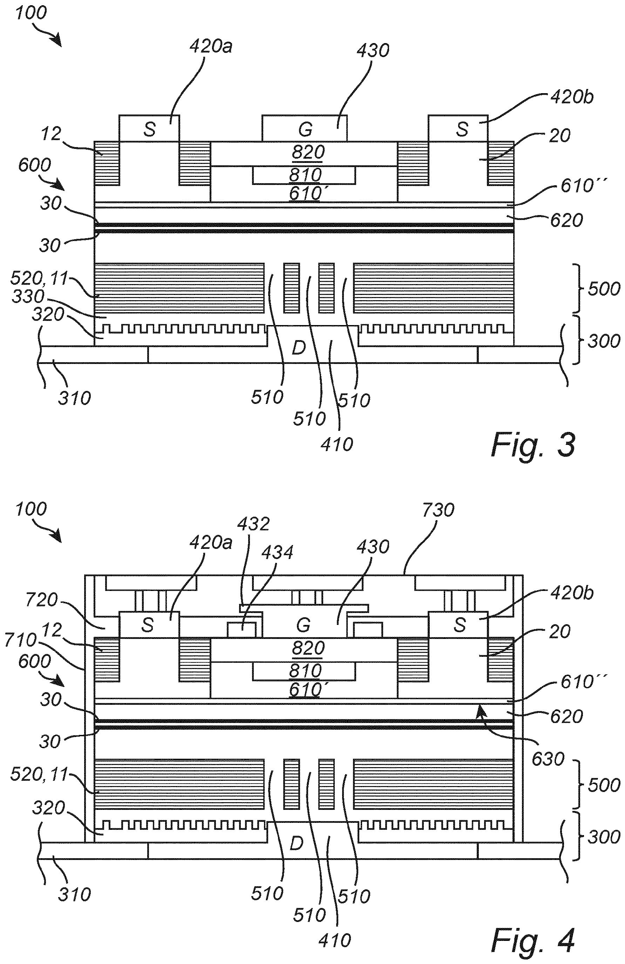

Fig. 4 illustrates a gate contact 430 with field plates 432 in the form of metal extensions of the gate contact 430 at an upper portion of the gate contact 430. The illustrated field plates 432 are vertically separated from the underlying semiconductor by a dielectric material 434. The dielectric material 434 may be Al₂O₃. The source contacts 420a, 420b may comprise corresponding field plates 432 which extend above the gate contact 430. Two The source contacts 420a, 420b may have a common field plate 432 extending above the gate contact 430.

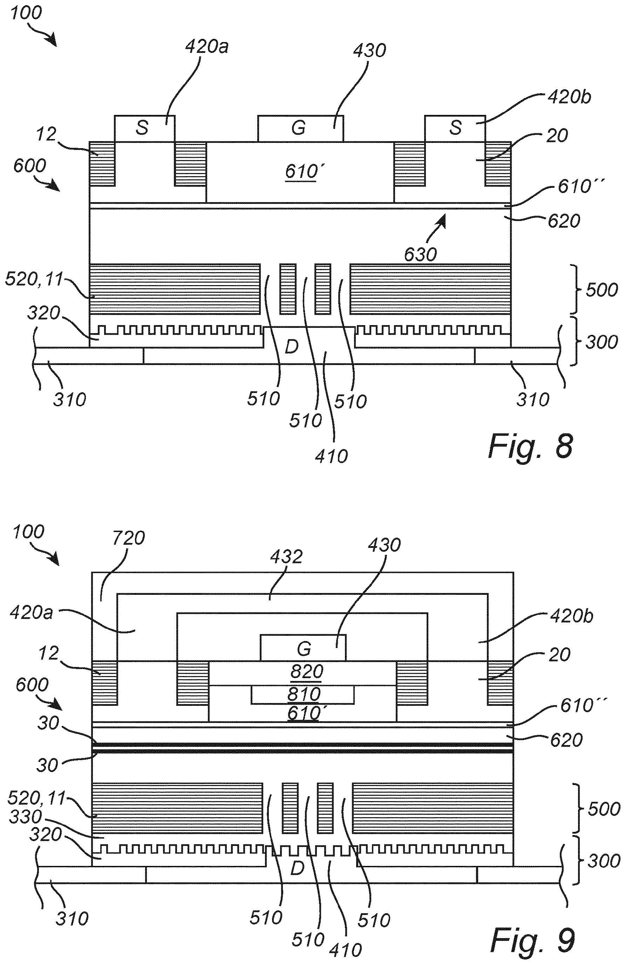

One or more field plates 432 may alternatively, or additionally, be arranged on one or more source contacts 420a, 420b. Fig.9 illustrates a common field plate 432 between a first 420a and second 420b source contact, the common field plate 432 extending above the gate contact 430.

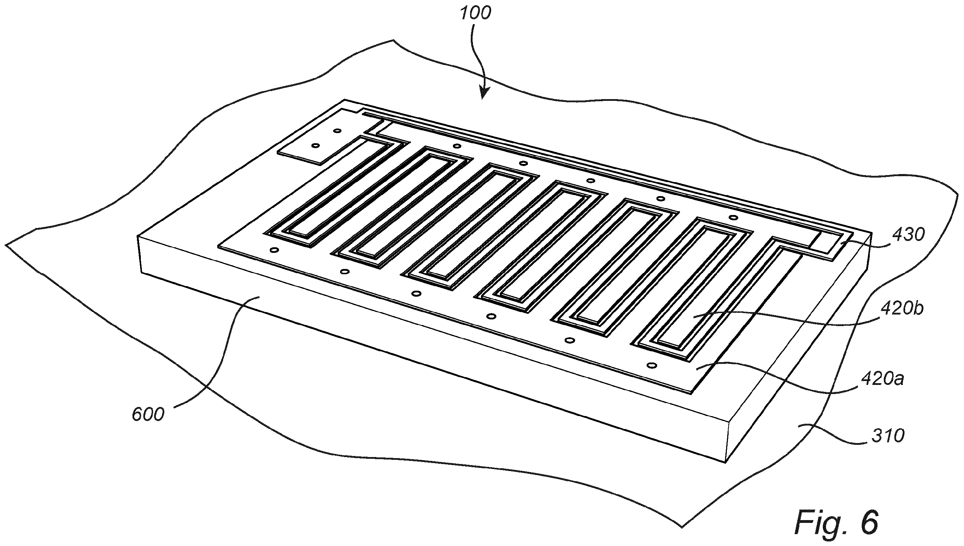

It should be understood that Figs. 1-4 are schematic cross-sectional views. There may be more than two source contacts 420a, 420b. Further, the source contacts 420a, 420b may be shaped in various ways. As an example, Fig. 6 illustrates a configuration of source contacts 420a, 420b as two interdigitated contacts with a gate contact 430 meandering between. The contacts are illustrated on the heterostructure mesa 600 on the substrate 310.

The nitride semiconductor structure between the gate contact 430 and the heterojunction 630 may be implemented in various ways as exemplified in Figs. 1-4.

In a first example, the gate contact 430 is arranged directly on the AlGaN-layer 610 that forms part of the heterojunction 630, as illustrated in Fig. 1. The AlGaN-layer 610 that forms part of the heterojunction 630 may herein be intrinsically doped or n-doped or comprise a n-doped layer close to, e.g. within 100 nm, of the heterojunction 630.

In a second example, the gate contact 430 is arranged on a p-doped GaN layer 820 that in turn is arranged above the AlGaN-layer 610 forming part of the heterojunction 630, as illustrated in Figs. 2-4. The p-doped GaN layer 820 may herein be arranged directly on the AlGaN-layer 610 forming part of the heterojunction 630, e.g. directly on the first AlGaN-sublayer 610' as illustrated in Fig. 2. Alternatively, the p-doped GaN layer 820 may be arranged on an intrinsically doped GaN layer 810 which in turn is arranged on an intrinsically doped AlGaN-layer 610' forming part of the heterojunction 630, as illustrated in Figs. 3-4. Further, as illustrated in Figs. 3-4, the intrinsically doped GaN layer 810 may be partially embedded in the intrinsically doped AlGaN-layer 610 (in the figures embedded in the first AlGaN-sublayer 610'). The intrinsically doped GaN layer 810 may have a thickness of at least 14 nm. The combined thickness of the intrinsically doped GaN layer 810 and the intrinsically doped AlGaN-layer 610 may be in the range 20-50 nm. Thus, in Figs. 3-4 the distance from the heterojunction 630 to the top of the intrinsically doped GaN layer 810 may be 20-50 nm.

In a third example, the gate contact 430 is arranged directly on the first AlGaN-sublayer 610' as illustrated in Fig. 8.

The heterojunction 630 may guide electrons laterally from the source contacts 420a, 420b to the vertical pillars 510. Additionally, the vertical HEMT may comprise one or more quantum wells 30, wherein said quantum wells 30 are configured to also guide electrons laterally from the source contacts 420a, 420b to the vertical pillars 510. Such quantum wells are illustrated in Figs. 3-4. The quantum wells may be arranged in the GaN-layer 620 forming part of the heterojunction 630. The one or more quantum wells may be InGaN quantum wells 30.

The materials or the above discussed features of the vertical HEMT 100 may be combined in various ways. A non-limiting example of material choices for the vertical HEMT 100 of Fig. 4 is:
A silicon <111> substate with a sputtered AIN layer 320 on the substrate 310, and a sputtered GaN layer 330 on said AIN layer 320. The pillar layer 500 comprises n-doped GaN vertical pillars 510 and supporting material 520 in the form of a first current blocking layer 11. The first current blocking layer 11 comprises a superlattice of GaN layers and AIN spacer layers wherein the AIN spacer layers have a thickness less than 5 nm and the GaN layers of the superlattice is carbon-doped or iron-doped. Above the pillar layer 500 there is a layer of n-doped GaN followed by two InGaN quantum wells separated by GaN, followed by the heterostructure forming the heterojunction 630. The heterostructure comprises a first AlGaN-sublayer 610' in the form of an Al_{(0.27)}Ga_{(0.73)}N layer having a thickness in the range 10-25 nm, a second AlGaN-sublayer 610" in the form of an AIN spacer of 1 nm thickness, and a GaN-layer 620, wherein the heterojunction 630 is formed at the interface between the AIN spacer 610" and the GaN-layer 620. The first AlGaN-sublayer 610' is intrinsically doped and above the first AlGaN-sublayer 610' there is an intrinsically doped GaN layer 810 followed by a p-doped GaN layer 820 and the gate contact 430, the gate contact 430 comprising Ni/AI. Further, there are ohmic source contacts 420a, 420b comprising Ti/Al/NiV and a gate contac comprising TiN/Al/TiN. Vertical connections 20 of n-doped GaN leads from each source contact 420a, 420b to the AIN spacer 610".

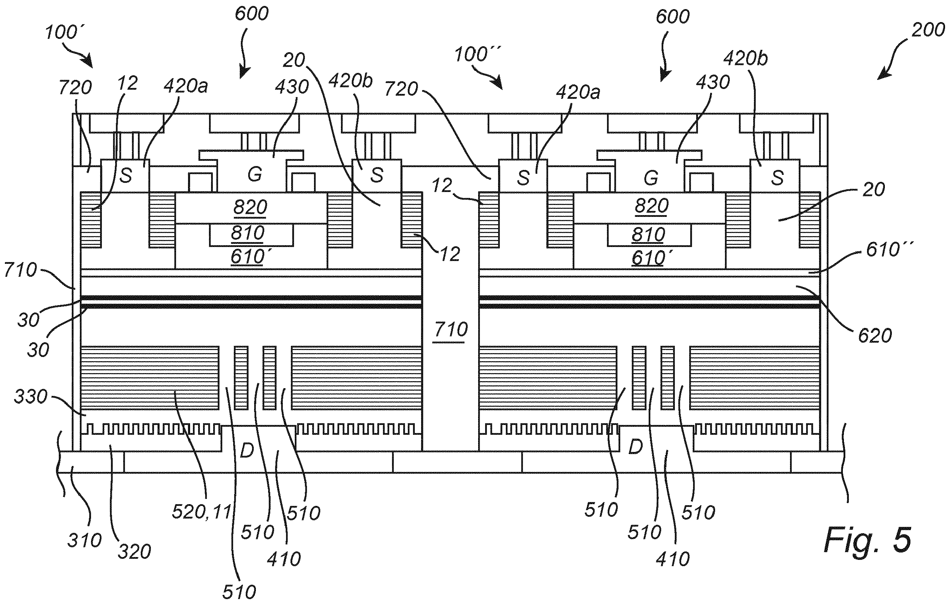

Two or more vertical HEMTs 100 may form an electrical circuit 200 such as a half-bridge. An electrical circuit 200 comprising a first vertical HEMT 100' and a second vertical HEMT 100" is illustrated in Fig. 5. The first 100' and second 100" vertical HEMT of Fig. 5 share a common substrate 310. The first 100' and second 100" vertical HEMT of Fig. 5 may be seen as corresponding to the vertical HEMT described in conjunction with Fig. 4. As understood by the skilled person in an electrical circuit 200 the source contact 420 / gate contact 430 / drain contact 410 of the first vertical HEMT 100' may be connected in various ways to the source contact 420 / gate contact 430 / drain contact 410 of the second vertical HEMT 100". Such connections are therefore not explicitly illustrated in Fig. 5.

As seen in Fig. 5 there is a first electrical insulator 710 arranged on the lateral sides of the heterostructure mesa 600 of the first 100' and second 100" vertical HEMT. In particular, there is a first electrical insulator 710 arranged between the heterostructure mesas 600 of the first 100' and second 100" vertical HEMT.

Further, there is a second electrical insulator 720 arranged on the lateral sides of the source contacts 420a, 420b of the first 100' and second (100") vertical HEMT. In Fig. 5 the first 710 and second 720 electrical insulator is the same electrical insulator.

Further, there is a second current blocking layer 12 arranged on the lateral sides of the GaN vertical connections 20. The second current blocking layer 12 comprises carbon-doped or iron doped GaN. In the illustration the second current blocking layer 12 comprises a superlattice of GaN layers and AIN spacer layers wherein the AIN spacer layers have a thickness less than 5 nm and the GaN layers of the superlattice is carbon-doped or iron-doped.

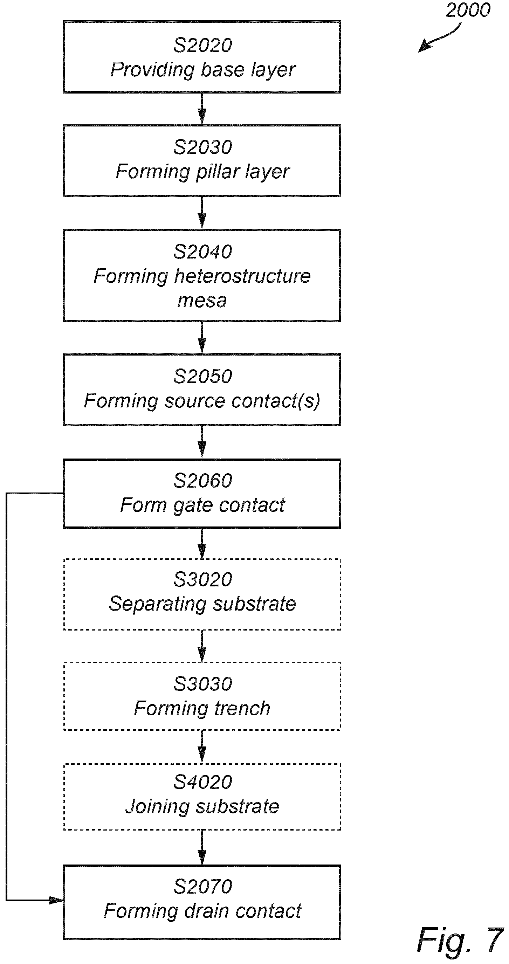

Fig. 7 illustrates a method 2000 for producing a vertical HEMT 100. According to the method 2000 a base layer 300 is provided S2020 wherein the base layer 300 comprises a substrate 310. Providing S2020 a base layer 300 may comprise providing a silicon <111> substrate 310 and sputtering an Al_{(1-y)}Ga_{(y)}N -layer 320 on the substrate, wherein 0≤y≤1, and sputtering a GaN layer 330 on said sputtered Al_{(1-y)}Ga_{(y)}N-layer 320. The Al_{(1-y)}Ga_{(y)}N-layer 320 may be a AIN layer 320 and will in the following be described as such. The sputtered AIN layer 320 may be patterned before sputtering the GaN layer 330. The sputtered AIN layer 320 may be patterned to form a corrugated surface, e.g. to form base layer pillars.

A pillar layer 500 is formed S2030 on the base layer 300, wherein the pillar layer 500 comprises at least one vertical pillar 510 and a supporting material 520 laterally enclosing the at least one vertical pillar 510. Forming the pillar layer may comprise epitaxially growing pillar material, e.g. n-doped GaN and then etching out the vertical pillars 510. A supporting material 520 may then be deposited, e.g. by epitaxial regrowth, around the vertical pillars 510. For example, epitaxial regrowth of iron-doped or carbon-doped GaN may form a first current blocking layer 11 enclosing the vertical pillars 510.

Further nitride semiconductor layers may then be epitaxially grown, said layers including a heterostructure comprising an AlGaN-layer 610 and a GaN-layer 620, together forming a heterojunction 630. A mesa is then etched out of the epitaxially grown layers such that a heterostructure mesa 600 is formed S2040.

At least one source contact 420a, 420b is formed S2050, e.g. by depositing metal in a lithographically defined area on the heterostructure mesa 600.

A gate contact 430 is formed S2060 above both the heterostructure mesa 600 and the at least one vertical pillar 510, such as on a top surface of the heterostructure mesa 600 and above the at least one vertical pillar 510. The gate contact may be formed S2060 by e.g. depositing metal in a lithographically defined area on the heterostructure mesa 600.

The method 2000 may further comprise separating S3020 the substrate 310 from the AlN-layer 320 using substrate removal or separation techniques.

The method 2000 may further comprise forming S3030 a trench in the AlN-layer 320. The trench may extend also into the GaN layer 330, possibly all the way to the at least one vertical pillar 510. The trench may be formed by etching a lithographically defined area on the bottom side of the AlN-layer 320. Said area may be lithographically defined by the same mask used to lithographically define the gate contact 430.

The method 2000 may further comprise etching through at least part of the substrate 310 by deep reactive ion etching to form a hole through the substrate 310. Then the substrate may be joined S4020 to the AlN-layer 320 such that the hole through the substrate 310 connects to the trench. The hole may be larger than the trench. If precise alignment is desired in joining, automated stepper equipment may be employed to aid the alignment.

According to the method 2000 a drain contact 410 electrically connected to the at least one vertical pillar 510 is formed S2070. The drain contact 410 is formed S2070 as a metal contact via through the substrate 310.

The drain contact 410 may be formed S2070 by depositing metal in the hole through the substrate 310 and in the trench in the AlN-layer 320.

As an alternative to separating S3020 and joining S4020 the substrate 310 from and to the AlN-layer 320 the substrate 310 may remain attached to the AlN-layer 320. A hole through the substrate 310 may be etched, e.g. at least partially by deep reactive ion etching, possibly also into the AlN-layer 320 and then filled with metal to form the drain contact 410. In order to stop the etch at the correct depth spectroscopic detection may be employed. For example, when the base layer 300 is formed an InGaN layer may be deposited, e.g. on top of the AlN-layer 320 or on top of the GaN-layer 330. When the hole is etched through the substrate 310 a spectroscopic wavelength signal relating to In may indicate that the InGaN layer is reached. Etching may then be stopped.

During etching of a sputtered AlN-layer 320 with base layer pillars the etch rate of the AIN in the base layer that is GaN overgrowth between AIN pillars may be faster than the etch rate of the GaN in the GaN-layer 330 which encloses the base layer pillars. Thus, a pattern corresponding to the base layer pillars may be transferred to the drain contact 410 such that the drain contact 410 also comprises pillars, said pillars extending into the nitride semiconductor layers, as illustrated in Fig. 9. Such pillars of the drain contact 410 may advantageously increase the contact surface between the drain contact 410 and the nitride semiconductor layers above.

Alternatively during etching of a substantially thin AlN-layer and a substantially thick sputtered GaN-layer 320 with base layer pillars the etch rate of the MOCVD GaN in the base layer that is GaN overgrowth between sputtered GaN pillars may etch with the same order of magnitude i.e. 1:1. Thus, a trench may be formed in the sputtered AIN and sputtered GaN stack for the drain contact 410 such that the drain contact 410 do not comprise any vertical pillars. The drain contact formed with a substantially thin sputtered AlN-layer together with a sputtered GaN-layer to improve the crystalline quality due to lattice-matched overgrowth of MOCVD GaN whereas the sputtered AIN prevents GaN from alloying with silicon at high temperature.

In one embodiment of the invention, the substrate used for etching a via may be silicon carbide.

### PREFERRED EMBODIMENTS

In one preferred embodiment of the invention there is provided a vertical high-electron-mobility transistor, HEMT (100), comprising: a substrate (310); a drain contact (410), the drain contact (410) being a metal contact via through said substrate (310); a pillar layer (500) arranged above the drain contact (410) and comprising at least one vertical pillar (510) and a supporting material (520) laterally enclosing the at least one vertical pillar (510); a heterostructure mesa (600) arranged on the pillar layer (500), the heterostructure mesa (600) comprising an AlGaN-layer (610) and a GaN-layer (620), together forming a heterojunction (630); at least one source contact (420a, 420b) electrically connected to the heterostructure mesa (600); a gate contact (430) arranged on said heterostructure mesa (600), and above the at least one vertical pillar (510); wherein the at least one vertical pillar (510) is forming an electron transport channel between the drain contact (410) and the heterojunction (630). It is preferred that the AIGaN layer (610) of the heterojunction (630) is intrinsically doped. The vertical HEMT (100) may comprise an intrinsically doped GaN layer (810) arranged above the intrinsically doped AIGaN layer (610) of the heterojunction (630), and aligned laterally over the at least one vertical pillar (510), wherein said GaN layer (810) has a thickness of at least 14 nm and a combined thickness of said GaN layer (810) and the AIGaN layer (610) of the heterojunction (630) is in the range 20-50 nm. The vertical HEMT (100) may comprise a p-doped GaN layer arranged above the AlGaN-layer (610) of the heterojunction (630), and underneath the gate contact (430). The p-doped GaN may comprises a superlattice comprising GaN and AI(1-x)Ga(x)N layers, wherein 0.2 ≤ x ≤ 0.4. The superlattice may comprise a plurality of heterostructure layers, wherein each heterostructure layer comprises one GaN layer and one AI(1-x)Ga(x)N layer. The superlattice may provide a p-type two-dimensional hole gas, 2DHG, providing a channel for conduction along an interface between two layers. A periodicity of the superlattice may be between 2 and 6 nm. Alternatively, the p-GaN may be annealed at high temperature that may deteriorate device doping profiles to remove hydrogen in lattice vacancies. A distance between the gate contact (430) and the heterojunction (630) may be configured such that a voltage difference of at least 1 V between the gate contact (430) and the at least one source contact (420a, 420b) opens a conductive channel at the heterojunction (630), whereby the vertical HEMT (100) has a threshold voltage of at least 1 V. The drain contact (410) may be laterally enclosed by an AlN-layer and/or an AlGaN-layer and/or a GaN-layer. The vertical HEMT (100) may be laterally aligned with the gate contact (430). The vertical HEMT (100) may be laterally separated from the at least one vertical pillar (510). The vertical HEMT (100) may have a lateral separation between the at least one source contact (420a, 420b) and the at least one vertical pillar (510) is at least 200 nm. The vertical HEMT (100) may comprise the supporting material (520) configured to be a current blocking layer (11). The at least one vertical pillar (510) may comprise n-doped GaN and wherein the supporting material (520) comprises a p-doped nitride semiconductor. The vertical HEMT (100) material (520) may comprises a superlattice of carbon-doped or iron-doped GaN layers and AIN spacer layers with a thickness less than 5 nm.

In another preferred embodiment of the invention there is provided an electrical circuit comprising a first (100') and a second (100") vertical HEMT, the first (100') and second (100") vertical HEMTs being vertical HEMTs according to any one of the preceeding claims, the electrical circuit comprising an electrical separator configured to block current between the first (100') and second (100") vertical HEMT, the electrical separator comprising: a first electrical insulator (710) arranged on a lateral side of the heterostructure mesa of at least one of the first (100') and second (100") vertical HEMT; and/or a second electrical insulator (720) arranged on a lateral side of the at least one source contact (420a, 420b) of at least one of the first (100') and second (100") vertical HEMT; and/or a current blocking layer (12) arranged on a lateral side of a GaN vertical connection, the GaN vertical connection (20) being an electrical connection between the at least one source contact (420a, 420b) and the heterostructure mesa (600) of at least one of the first (100') and second (100") vertical HEMT, wherein said current blocking layer comprises carbon-doped or iron doped GaN.

A method (2000) for producing a vertical HEMT (100), the method (2000) comprising providing (S2020) a base layer (300) wherein the base layer (300) comprises a substrate (310); forming (S2030) a pillar layer (500) on the base layer (300), wherein the pillar layer (500) comprises at least one vertical pillar (510) and a supporting material (520) laterally enclosing the at least one vertical pillar (510); forming (S2040) a heterostructure mesa (600) on the pillar layer (500), the heterostructure mesa (600) comprising an AlGaN-layer (610) and a GaN-layer (620), together forming a heterojunction (630); forming (S2050) at least one source contact (420a, 420b) electrically connected to the heterostructure mesa (600); forming (S2060) a gate contact (430) above both the heterostructure mesa and the at least one vertical pillar (510); and forming (S2070) a drain contact (410) electrically connected to the at least one vertical pillar (510), the drain contact (410) being a metal contact via through the substrate (310); wherein the at least one vertical pillar (510) is forming an electron transport channel between the drain contact (410) and the heterojunction (630). The base layer (300) may comprise an Al_{(1-y)}Ga_{(y)}N-layer (320) on the substrate (310), wherein said Al_{(1-y)}Ga_{(y)}N-layer (320) is sputtered epitaxially aligned with the crystal orientation of the substrate (310), preferably wherein said substrate (310) is silicon <111> and said composition y is either 0 or 1, or a value therebetween. Forming (S2070) the drain contact (410) may comprise etching through at least part of the substrate (310) by deep reactive ion etching.

In one preferred embodiment of the invention there is provided a high-electron-mobility transistor, HEMT (100), comprising: a substrate (310); a drain contact (410), the drain contact; a heterostructure mesa (600), the heterostructure mesa (600) comprising an AlGaN-layer (610) and a GaN-layer (620), together forming a heterojunction (630); a source contact (420a) and a drain contact (420b) electrically connected to the heterostructure mesa (600); a gate contact (430) arranged on said heterostructure mesa (600). The gate contact may comprise a TiN/Al/TiN. It is preferred that the AIGaN layer (610) of the heterojunction (630) is intrinsically doped. The AI(x)Ga(1-x)N-layer (610) may further comprise a thickness of 20-22 nm and a composition x of Al at 25-28% and a GaN-layer (620), together forming a heterojunction (630). The HEMT (100) may comprise an intrinsically doped GaN layer (810) arranged above the intrinsically doped AIGaN layer (610) of the heterojunction (630). The HEMT (100) may comprise a p-doped GaN layer arranged above the AlGaN-layer (610) of the heterojunction (630), and underneath the gate contact (430). A distance between the gate contact (430) and the heterojunction (630) may be configured such that a voltage difference of at least 1 V between the gate contact (430) and the at least one source contact (420a, 420b) opens a conductive channel at the heterojunction (630), whereby the HEMT (100) has a threshold voltage of at least 1 V. The drain contact (410) may be laterally enclosed by an AlN-layer and/or an AIGaN-layer and/or a GaN-layer. The vertical HEMT (100) may be laterally aligned with the gate contact (430). The vertical HEMT (100) may be laterally separated from the at least one vertical pillar (510). The HEMT (100) may have a lateral separation between the at least one source contact (420a, 420b) and the at least one vertical pillar (510) is at least 200 nm. The vertical HEMT (100) may comprise the supporting material (520) configured to be a current blocking layer (11). The HEMT (100) material (520) may comprises a superlattice of carbon-doped or iron-doped GaN layers and AIN spacer layers with a thickness less than 5 nm.

In another preferred embodiment of the invention there is provided an electrical circuit comprising a first (100') and a second (100") HEMT, the first (100') and second (100") comprising an electrical separator configured to block current between the first (100') and second (100") HEMT, the electrical separator comprising: a first electrical insulator (710) arranged on a lateral side of the heterostructure mesa of at least one of the first (100') and second (100") HEMT; and/or a second electrical insulator (720) arranged on a lateral side of the at least one source contact (420a, 420b) of at least one of the first (100') and second (100") HEMT; and/or a current blocking layer (12) arranged on a lateral side of a GaN vertical connection, the GaN vertical connection (20) being an electrical connection between the at least one source contact (420a, 420b) and the heterostructure mesa (600) of at least one of the first (100') and second (100") HEMT, wherein said current blocking layer comprises carbon-doped or iron doped GaN. The HEMT (100) may comprise a p-doped GaN layer arranged above the AlGaN-layer (610) of the heterojunction (630), and underneath the gate contact (430). The p-doped GaN may comprises a superlattice comprising GaN and AI(y)Ga(1-y)N layers, wherein 0.2 ≤ x ≤ 0.4. The superlattice may comprise a plurality of heterostructure layers, wherein each heterostructure layer comprises one GaN layer and one Al(z)Ga(1-)N layer. The superlattice may provide a p-type two-dimensional hole gas, 2DHG, providing a channel for conduction along an interface between two layers. A periodicity of the superlattice may be between 2 and 6 nm. Alternatively, the p-GaN may be annealed at high temperature that may deteriorate device doping profiles to remove hydrogen in lattice vacancies.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A vertical high-electron-mobility transistor, HEMT (100), comprising:
a substrate (310);
a drain contact (410), the drain contact (410) being a metal contact via through said substrate (310);
a pillar layer (500) arranged above the drain contact (410) and comprising at least one vertical pillar (510) and a supporting material (520) laterally enclosing the at least one vertical pillar (510);
a heterostructure mesa (600) arranged on the pillar layer (500), the heterostructure mesa (600) comprising an AlGaN-layer (610) and a GaN-layer (620), together forming a heterojunction (630);
at least one source contact (420a, 420b) electrically connected to the heterostructure mesa (600);
a gate contact (430) arranged on said heterostructure mesa (600), and above the at least one vertical pillar (510);
wherein the at least one vertical pillar (510) is forming an electron transport channel between the drain contact (410) and the heterojunction (630).

2. The vertical HEMT (100) according to claim 1, wherein the AIGaN layer (610) of the heterojunction (630) is intrinsically doped, the vertical HEMT (100) further comprising:
an intrinsically doped GaN layer (810) arranged above the intrinsically doped AIGaN layer (610) of the heterojunction (630), and aligned laterally over the at least one vertical pillar (510), wherein said GaN layer (810) has a thickness of at least 14 nm and a combined thickness of said GaN layer (810) and the AIGaN layer (610) of the heterojunction (630) is in the range 20-50 nm.

3. The vertical HEMT (100) according to any one of the preceding claims, further comprising a p-doped GaN layer arranged above the AlGaN-layer (610) of the heterojunction (630), and underneath the gate contact (430).

4. The vertical HEMT (100) according to any one of the preceding claims, wherein a distance between the gate contact (430) and the heterojunction (630) is configured such that a voltage difference of at least 1 V between the gate contact (430) and the at least one source contact (420a, 420b) opens a conductive channel at the heterojunction (630), whereby the vertical HEMT (100) has a threshold voltage of at least 1 V.

5. The vertical HEMT (100) according to any one of the preceding claims, wherein the drain contact (410) is laterally enclosed by an AlN-layer and/or an AlGaN-layer and/or a GaN-layer.

6. The vertical HEMT (100) according to any one of claims, wherein the at least one vertical pillar (510) is laterally aligned with the gate contact (430).

7. The vertical HEMT (100) according to any one of the preceding claims, wherein the at least one source contact (420a, 420b) is laterally separated from the at least one vertical pillar (510).

8. The vertical HEMT (100) according to claim 7, wherein a lateral separation between the at least one source contact (420a, 420b) and the at least one vertical pillar (510) is at least 200 nm.

9. The vertical HEMT (100) according to any one of the preceding claims, wherein the supporting material (520) is configured to be a current blocking layer (11).

10. The vertical HEMT (100) according to any one of the preceding claims, wherein the at least one vertical pillar (510) comprises n-doped GaN and wherein the supporting material (520) comprises a p-doped nitride semiconductor.

11. The vertical HEMT (100) according to claim 9 or 10, wherein the supporting material (520) comprises a superlattice of carbon-doped or iron-doped GaN layers and AIN spacer layers with a thickness less than 5 nm.

12. The vertical HEMT (100) according any of the claims 3-11, wherein the p-doped GaN comprises a superlattice of p-doped AIGaN and intrinsically doped GaN.

13. An electrical circuit comprising a first (100') and a second (100") vertical HEMT, the first (100') and second (100") vertical HEMTs being vertical HEMTs according to any one of the preceeding claims, the electrical circuit comprising an electrical separator configured to block current between the first (100') and second (100") vertical HEMT, the electrical separator comprising:
a first electrical insulator (710) arranged on a lateral side of the heterostructure mesa of at least one of the first (100') and second (100") vertical HEMT; and/or
a second electrical insulator (720) arranged on a lateral side of the at least one source contact (420a, 420b) of at least one of the first (100') and second (100") vertical HEMT; and/or
a current blocking layer (12) arranged on a lateral side of a GaN vertical connection, the GaN vertical connection (20) being an electrical connection between the at least one source contact (420a, 420b) and the heterostructure mesa (600) of at least one of the first (100') and second (100") vertical HEMT, wherein said current blocking layer comprises carbon-doped or iron doped GaN.

14. A method (2000) for producing a vertical HEMT (100), the method (2000) comprising:
providing (S2020) a base layer (300) wherein the base layer (300) comprises a substrate (310);
forming (S2030) a pillar layer (500) on the base layer (300), wherein the pillar layer (500) comprises at least one vertical pillar (510) and a supporting material (520) laterally enclosing the at least one vertical pillar (510);
forming (S2040) a heterostructure mesa (600) on the pillar layer (500), the heterostructure mesa (600) comprising an AlGaN-layer (610) and a GaN-layer (620), together forming a heterojunction (630);
forming (S2050) at least one source contact (420a, 420b) electrically connected to the heterostructure mesa (600);
forming (S2060) a gate contact (430) above both the heterostructure mesa and the at least one vertical pillar (510); and
forming (S2070) a drain contact (410) electrically connected to the at least one vertical pillar (510), the drain contact (410) being a metal contact via through the substrate (310);
wherein the at least one vertical pillar (510) is forming an electron transport channel between the drain contact (410) and the heterojunction (630).

15. The method (2000) according to claim 14, wherein the base layer (300) comprises an Al_{(1-y)}Ga_{(y)}N-layer (320) on the substrate (310), wherein said Al_{(1-y)}Ga_{(y)}N-layer (320) is sputtered epitaxially aligned with the crystal orientation of the substrate (310), preferably wherein said substrate (310) is silicon <111> and said composition y is either 0 or 1, or a value therebetween.

16. The method (2000) according to any one of claims 13-15, wherein forming (S2070) the drain contact (410) comprises etching through at least part of the substrate (310) by deep reactive ion etching.

## Amended claims

### Amended claims in accordance with Rule 137(2) EPC.

1. A vertical high-electron-mobility transistor, HEMT (100), comprising:
a base layer (300);
a drain contact (410), the drain contact (410) being a metal contact via through said substrate (310);
a pillar layer (500) arranged above the drain contact (410) and comprising at least one vertical pillar (510) and a supporting material (520) laterally enclosing the at least one vertical pillar (510);
a heterostructure mesa (600) arranged on the pillar layer (500), the heterostructure mesa (600) comprising an AlGaN-layer (610) and a GaN-layer (620), together forming a heterojunction (630);
at least one source contact (420a, 420b) electrically connected to the heterostructure mesa (600);
a gate contact (430) arranged on said heterostructure mesa (600), and above the at least one vertical pillar (510);
wherein the at least one vertical pillar (510) is forming an electron transport channel between the drain contact (410) and the heterojunction (630);
wherein the base layer (300) comprises a substrate (310), an AIN layer (320) on the substrate (310) and a GaN layer (330) on the AIN layer (320);
wherein the AIN layer (320) comprises a corrugated surface formed from a plurality of base layer pillars and the GaN layer (330) laterally and vertically encloses the plurality of base layer pillars.

2. The vertical HEMT (100) according to claim 1, wherein the AlGaN layer (610) of the heterojunction (630) is intrinsically doped, the vertical HEMT (100) further comprising:
an intrinsically doped GaN layer (810) arranged above the intrinsically doped AlGaN layer (610) of the heterojunction (630), and aligned laterally over the at least one vertical pillar (510), wherein said GaN layer (810) has a thickness of at least 14 nm and a combined thickness of said GaN layer (810) and the AlGaN layer (610) of the heterojunction (630) is in the range 20-50 nm.

3. The vertical HEMT (100) according to any one of the preceding claims, further comprising a p-doped GaN layer arranged above the AlGaN-layer (610) of the heterojunction (630), and underneath the gate contact (430).

4. The vertical HEMT (100) according to any one of the preceding claims, wherein a distance between the gate contact (430) and the heterojunction (630) is configured such that a voltage difference of at least 1 V between the gate contact (430) and the at least one source contact (420a, 420b) opens a conductive channel at the heterojunction (630), whereby the vertical HEMT (100) has a threshold voltage of at least 1 V.

5. The vertical HEMT (100) according to any one of the preceding claims, wherein the drain contact (410) is laterally enclosed by an AIN-layer and/or an AlGaN-layer and/or a GaN-layer.

6. The vertical HEMT (100) according to any one of claims, wherein the at least one vertical pillar (510) is laterally aligned with the gate contact (430).

7. The vertical HEMT (100) according to any one of the preceding claims, wherein the at least one source contact (420a, 420b) is laterally separated from the at least one vertical pillar (510).

8. The vertical HEMT (100) according to claim 7, wherein a lateral separation between the at least one source contact (420a, 420b) and the at least one vertical pillar (510) is at least 200 nm.

9. The vertical HEMT (100) according to any one of the preceding claims, wherein the supporting material (520) is configured to be a current blocking layer (11).

10. The vertical HEMT (100) according to any one of the preceding claims, wherein the at least one vertical pillar (510) comprises n-doped GaN and wherein the supporting material (520) comprises a p-doped nitride semiconductor.

11. The vertical HEMT (100) according to claim 9 or 10, wherein the supporting material (520) comprises a superlattice of carbon-doped or iron-doped GaN layers and AIN spacer layers with a thickness less than 5 nm.

12. The vertical HEMT (100) according any of the claims 1-11, further comprising a current blocking layer (12) arranged on a lateral side of a GaN vertical connection, the GaN vertical connection (20) being an electrical connection between the at least one source contact (420a, 420b) and the heterostructure mesa (600) of the vertical HEMT (100), wherein said current blocking layer comprises carbon-doped or iron doped GaN.

13. An electrical circuit comprising a first (100') and a second (100") vertical HEMT, the first (100') and second (100") vertical HEMTs being vertical HEMTs according to claim 13, the electrical circuit comprising an electrical separator configured to block current between the first (100') and second (100") vertical HEMT, the electrical separator comprising:
a first electrical insulator (710) arranged on a lateral side of the heterostructure mesa of at least one of the first (100') and second (100") vertical HEMT; and/or
a second electrical insulator (720) arranged on a lateral side of the at least one source contact (420a, 420b) of at least one of the first (100') and second (100") vertical HEMT; and/or
the current blocking layer (12) arranged on the lateral side of the GaN vertical connection of at least one of the first (100') and second (100") vertical HEMT.
